Europäisches Patentamt

European Patent Office

Office européen des brevets

(19)

(11) Veröffentlichungsnummer: **0 061 582**
**B1**

(12) **EUROPÄISCHE PATENTSCHRIFT**

(45) Veröffentlichungstag der Patentschrift:
**02.05.85**

(21) Anmeldenummer: **82101377.8**

(22) Anmeldetag: **24.02.82**

(51) Int. Cl.⁴: **H 04 B 7/14,** H 03 F 1/32,
H 04 B 7/005

(54) Verfahren und Schaltungsanordnung zur Kompensation der Nichtlinearitäten von Übertragungsgliedern in einem Richtfunkübertragungssystem.

(30) Priorität: **01.04.81 DE 3113005**

(43) Veröffentlichungstag der Anmeldung:
**06.10.82 Patentblatt 82/40**

(45) Bekanntmachung des Hinweises auf die Patenterteilung:
**02.05.85 Patentblatt 85/18**

(84) Benannte Vertragsstaaten:
**AT BE CH DE FR GB IT LI NL**

(56) Entgegenhaltungen:
**EP - A - 0 019 084**
**DE - A - 2 147 167**
**DE - A - 2 923 046**
**DE - B - 2 743 352**
**US - A - 3 825 843**

(73) Patentinhaber: **ANT Nachrichtentechnik GmbH,
Gerberstrasse 33, D-7150 Backnang (DE)**

(72) Erfinder: **Lenz, Sigmund, Dipl.-Ing., Kernerstrasse 17,
D-7152 Aspach 1 (DE)**

(74) Vertreter: **Schickle, Gerhard, Dipl.-Ing. et al, ANT
Nachrichtentechnik GmbH Patent- und Lizenzabteilung
Gerberstrasse 33, D-7150 Backnang (DE)**

**Beschreibung**

Die Erfindung betrifft ein Verfahren bzw. eine Schaltungsanordnung zur Kompensation der Nichtlinearitäten von Übertragungsgliedern in einem Richtfunkübertragungssystem gemäss Oberbegriff des Patentanspruchs 1 bzw. 4.

Die Übertragung amplitudenmodulierter Signale über Richtfunkstrecken erfordert eine hohe Linearität des Mikrowellensendeverstärkers. Diese Linearität kann im Verstärker selbst nicht erreicht werden.

Abhilfe kann auf zweierlei Arten geschaffen werden, zum einen nach der Vorverzerrungs-Methode (predistortion), und zum anderen nach der älteren Vorentzerrungs-Methode (feed forward).

Die letzgenannte Art der Linearisierung wird wegen des hohen Aufwandes für breitbandige Entzerrungsschaltungen meist nicht verwendet.

Schaltungen nach dem Vorverzerrerprinzip werden entweder in der Zwischenfrequenz- oder in der Radiofrequenzebene eingesetzt, wobei letztere eine kleinere relative Bandbreite, jedoch zumeist auch einen hohen Transmissionsverlust von ca. 7 bis 10 dB aufweist, der mit einem zusätzlichen Mikrowellenverstärker, beispielsweise einem FET-Verstärker, ausgeglichen werden muss.

Durch die DE-OS 2923046 ist ebenfalls eine Mischeranordnung mit Vorverzerrung in der RF-Ebene bekannt geworden, bei dem das Lokaloszillatorsignal dem Verzerrermischer über einen Pegel- und Phasenregler zugeführt und die unmittelbaren Mischerausgangssignale von Verzerrer- und Linearmischer durch einen Summierer zusammengefasst werden. Nachteilig bei dieser Schaltungsanordnung ist, dass je nach Phasenlage der störenden Nichtlinearität die Phase des Oszillatorsignals für den Verzerrermischer soweit gedreht werden muss, dass das Ausgangssignal des Verzerrermischers in den Bereich der Gegenphase zum HF-Ausgangssignal des Linearmischers gelangt, wodurch hohe Transmissionsdämpfungen bzw. hohe Mischverluste auftreten.

Aufgabe der vorliegenden Erfindung war es deshalb ein Verfahren bzw. eine Schaltungsanordnung zur Durchführung des Verfahrens zur Kompensation der Nichtlinearitäten von Übertragungsgliedern in einem Richtfunkübertragungssystem der oben genannten Art anzugeben, bei denen die Transmissionsverluste sehr niedrig gehalten werden, bei denen ausserdem die Einstellung der Verzerrung einfach ist und bei denen eine gute Gesamtentzerrung bei wenig Aufwand erreicht werden kann.

Die Aufgabe wird mit den in den Patentansprüchen 1 und 4 gekennzeichneten Merkmalen gelöst.

Die Erfindung bietet die Vorteile einer guten, wenig aufwendigen Kompensation der Nichtlinearität eines Richtfunkübertragungsgliedes, insbesondere einer Wanderwellenröhre, unter Ausnutzung der kleinen relativen Bandbreite in der Radiofrequenzebene und mit kleiner Transmissionsdämpfung. Von grossem Vorteil ist weiterhin, dass die erfindungsgemässe Schaltungsanordnung in integrierter Technik ausgeführt werden kann, wodurch an Platz und Aufwand eingespart werden kann. Von Vorteil ist ferner die gute Entkopplung zwischen dem Nutzsignal und den nichtlinearen Signalen, das praktisch unabhängig von der Einstellung deren Amplitude und Phase ist.

Die Erfindung baut auf der Erkenntnis auf, dass insbesondere bei Wanderfeldröhrensendeverstärkern die Nichtlinearität im wesentlichen die Intermodulationssignale dritter Ordnung beinhalten. Mit der Erfindung ist es möglich, die gleichen Mischprodukte durch den Verzerrermischer zu erzeugen, vom Nutzsignalanteil seines RF-Signals zu separieren und so in Amplitude und Phase einzustellen und dem RF-Nutzsignal wieder zuzumischen, dass das RF-Ausgangssignal des Sendeverstärkers keine störenden Mischprodukte mehr enthält.

Im folgenden wird die Erfindung anhand der Figuren beschrieben.

Fig. 1 zeigt ein Ausführungsbeispiel der erfindungsgemässen Kompensationsschaltungsanordnung;

Fig. 2a bis 2d zeigen spektrale Darstellungen der Signalamplituden an vier verschiedenen Stellen der Schaltungsanordnung nach Fig. 1.

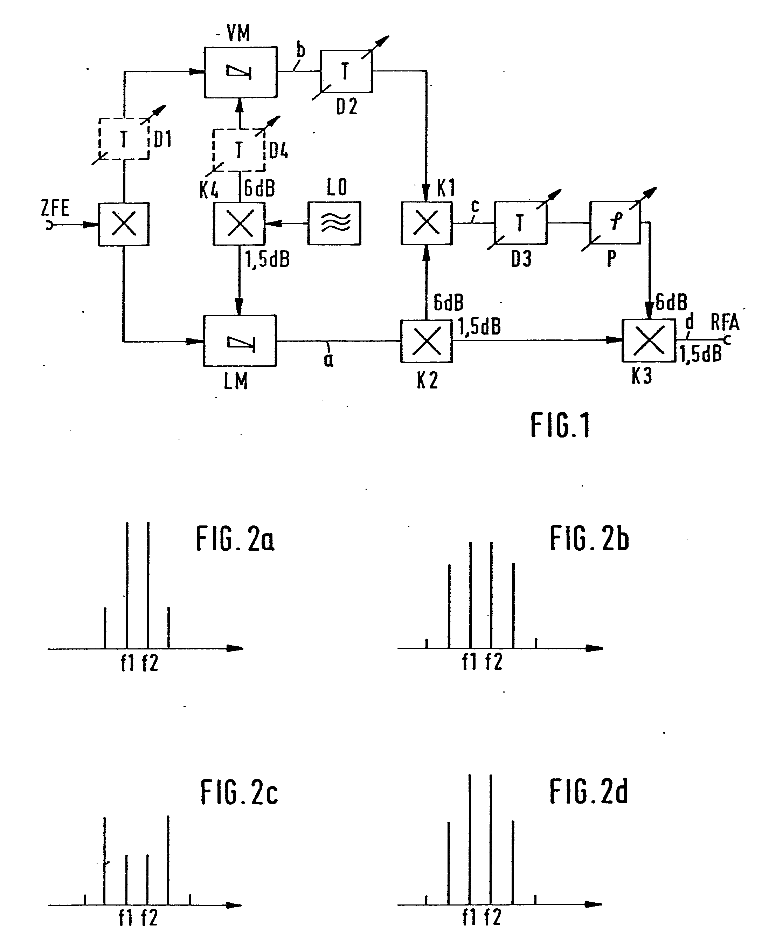

Das Blockschaltbild der Fig. 1 zeigt den Linearmischer LM und den Verzerrermischer VM, die beide über den ZF-Eingang ZFE über einen nicht näher gekennzeichneten Koppler mit dem ZF-Signal beaufschlagt werden und die beide über den Koppler K4 mit dem Signal des Lokaloszillators LO versorgt werden, wobei der Verzerrermischer über den 6-dB-Ausgang des Kopplers K4 unterversorgt wird und somit starke Nichtlinearität zeigt. Mittels eines dazwischen gefügten Dämpfungsgliedes D4 kann die Nichtlinearität des Verzerrermischers noch weiter variiert werden.

Zur Ermittlung des Nichtlinearitätsverhaltens des Mikrowellenverstärkers wird das Zwei-Ton-Intermodulationsmessverfahren verwendet. Hierbei werden zwei Töne f1 und f2 im Abstand von Δf innerhalb des Zwischenfrequenzbandes über den ZF-Eingang ZFE auf die Mischanordnung gegeben. Am Ausgang a des Linearmischers LM entsteht dann das Spektrum nach Fig. 2a mit den beiden ins Richtfunkband umgesetzten Tönen f1, f2 sowie den störenden Mischprodukten dritter Ordnung 2f2-f1 bzw. 2f1-f2. Am Ausgang b des Verzerrermischers VM entsteht das Spektrum nach Fig. 2b, bei dem eine Reduzierung des Nutzsignalpegels, aber auch eine deutliche Anhebung der Mischprodukte dritter Ordnung sowie ein kleiner Anteil fünfter Ordnung erkennbar ist. Die unerwünschten Anteile der fünften Ordnung können durch entsprechende Einstellung des Arbeitspunktes (einstellbarer Widerstand im Gleichstromkreis der Mikrowellenmischerdiode) des Verzerrermischers und mit Hilfe der Dämpfungsglieder D1, D4 im ZF- bzw. LO-Zweig weitgehend unterdrückt werden. Zur Separierung der Mischprodukte dritter Ordnung ist nun ein weiterer Koppler K1 vorgesehen, in den das Ausgangssignal des Verzerrermischers und ein über einen weiteren Koppler K2 ausgekoppelter kleiner Anteil des Ausgangssignals des Linearmischers gegenphasig zusammengefasst werden, wodurch bei richtiger Wahl der Koppeldämpfungen die Nutzsignale ausgelöscht werden können. Zum besseren Abgleich ist ein weiteres Dämpfungsglied D2 zwischen Ausgang des Verzerrermischers und Koppler K einzufügen. Am Ausgang c des Kopplers K1 entsteht das Signal mit dem Spektrum nach Fig. 2c, in dem deutlich sichtbar die Überhöhung der Mischprodukte dritter Ordnung gegenüber den stark unterdrückten Nutzsignaltönen ist. Dieses Ausgangssignal wird anschliessend mittels eines nachfolgenden Dämpfungsgliedes D3 und eines Phasengliedes P in Amplitude und Phase eingestellt und über einen 6-dB-Eingang eines weiteren Kopplers K3 dem den Koppler K2 passierenden Ausgangssignal des Linearmischers hinzuaddiert. Am Ausgang d des Kopplers K3 liegt das Summensignal mit dem Spektrum nach Fig. 2d, in dem deutlich die gegenüber dem vollen Nutzsignalpegel angehobenen Modulationsprodukte dritter Ordnung erkennbar sind.

Die beschriebene Anordnung weist einen sehr niedrigen RF-Transmissionsverlust von 2×1,5 dB auf.

Bei einem 6-GHz-Richtfunk-Gerät mit 10-Watt-Wanderfeldröhrenverstärker (z. B. mit Röhre YH 1202), welches eine Bandbreite von etwa 40 MHz aufweist, konnte eine Reduktion der störenden Mischproduktanteile dritter Ordnung um mehr als 20 dB erreicht werden, so dass ein Störabstand von über 70 dB ohne weiteres möglich ist.

Die Mischeranordnungen waren bei dem realisierten Schaltungsbeispiel Einseitenbandmischer, bei dem Oszillatorsignal und unerwünschtes Seitenband um mehr als 15 dB gegenüber dem Nutzseitenband unterdrückt sind. Das erfindungsgemässe Verfahren bzw. die Anordnung beschränkt sich jedoch nicht auf Einseitenbandmischer, selbstverständlich können auch Zweiseitenbandmischer verwendet werden.

Anstelle der Koppler können natürlich auch andere Summierglieder wie Zirkulatoren usw. verwendet werden. Bei sehr grossen Ausgangspegeln der Wanderfeldröhrenverstärker können die Intermodulationsprodukte 3. Ordnung unverhältnismässig hohe Werte Annehmen, welche die mit einem Verzerrermischer realisierbaren Werte übersteigen, so dass eine Kompensation nicht mehr möglich ist. Für solche extremen Fälle können die notwendigen Pegel durch mehrere parallel arbeitende Verzerrermischer erzeugt werden.

## Patentansprüche

1. Verfahren zur Kompensation der Nichtlinearitäten von Übertragungsgliedern nach Betrag und Phase in einem Richtfunkübertragungssystem mittels eines Phasenschiebers (P), mittels eines Dämpfungsgliedes (D), mittels eines im linearen (Linearmischer, LM) und eines im verzerrenden Bereich (Verzerrermischer, VM) arbeitenden Mischers, in denen das mit dem Nutzsignal beaufschlagte Zwischenfrequenz (ZF)-signal durch das Lokaloszillator (LOI)-signal in den Radiofrequenz (RF)-bereich umgesetzt wird, und mittels eines Summiergliedes (K3), durch das die beiden Mischerausgangssignale zusammengefasst werden, wobei der Arbeitspunkt des Verzerrermischers (VM) so eingestellt wird, dass sein Ausgangssignal (b) neben dem Nutzsignalanteil im wesentlichen nur Intermodulationsprodukte dritter Ordnung aufweist, dadurch gekennzeichnet, dass ein Netzwerk vorgesehen ist, durch das der Nutzsignalanteil im Ausgangssignal (b) des Verzerrermischers (VM) weitgehend unterdrückt wird (K1, c), dass das Netzwerk ein Dämpfungsglied (D3) enthält zur Einstellung der Amplitude lediglich der verbleibenden Intermodulationsprodukte dritter Ordnung, dass das Netzwerk ferner einen Phasenschieber (P) enthält zur Einstellung der Phasenlage lediglich der Intermodulationsprodukte dritter Ordnung oder lediglich des Ausgangssignals (a) des Linearmischers (LM) und dass diese so eingestellten Signale durch das Summierglied (K3) zusammengefasst werden (d).

2. Verfahren nach Anspruch 1, dadurch gekennzeichnet, dass das Summierglied ein Koppler (K3) ist.

3. Verfahren nach Anspruch 1 oder 2, dadurch gekennzeichnet, dass zur Unterdrückung des Nutzsignalanteils ein Teil des Ausgangssignales (a) des linearen Mischers (LM) ausgekoppelt (K2) und gegenphasig zum Ausgangssignal (b) des Verzerrermischers (VM) addiert (K1) wird.

4. Schaltungsanordnung zur Durchführung des Verfahrens nach einem der Ansprüche 1 bis 3, dadurch gekennzeichnet, dass das Netzwerk zwei dreiarmige Koppler (K1, K2) enthält, deren Eingänge jeweils mit einem Mischerausgang verbunden sind, dass der mit dem Ausgang des Verzerrermischers (VM) verbundene erste Koppler (K1) einen zweiten Eingang und einen Ausgang aufweist, welcher Eingang mit dem ersten Ausgang des zweiten Kopplers (K2) und welcher Ausgang über ein Dämpfungsglied (D3) und über einen Phasenschieber (P) mit dem ersten Eingang eines dritten dreiarmigen Kopplers (K3) verbunden ist, dass der zweite Koppler (K2) einen zweiten Ausgang aufweist, der mit dem zweiten Eingang des dritten Kopplers (K3) verbunden ist, an dessen Ausgang (RFA) das vorverzerrte RF-Signal (d) abgreifbar ist.

5. Schaltungsanordnung nach Anspruch 4, dadurch gekennzeichnet, dass dem ZF-Eingang und dem RF-Ausgang des Verzerrermischers (VM) jeweils ein Dämpfungsglied (D1, D2) vor- bzw. nachgeschaltet ist.

6. Schaltungsanordnung nach Anspruch 4 oder 5, dadurch gekennzeichnet, dass der zweite Koppler (K2) an seinem zweiten Ausgang und der dritte Koppler (K3) an seinem zweiten Eingang eine geringe Durchlassdämpfung (1,5 dB) aufweisen.

7. Schaltungsanordnung nach Anspruch 4, 5 oder 6, dadurch gekennzeichnet, dass zur Einspeisung des LO-Signals in die Mischer ein weiterer dreiarmiger Koppler (K4) verwendet wird, der an dem mit dem Linearmischer (LM) verbundenen Ausgang geringe Durchlassdämpfung (1,5 dB) und an dem mit dem Verzerrermischer (VM) verbundenen Ausgang eine nicht so geringe Durchlassdämpfung (6 dB) aufweist.

8. Schaltungsanordnung nach einem der Ansprüche 4 bis 7, dadurch gekennzeichnet, dass der erste Koppler (K1) durch einen dreiarmigen Zirkulator ersetzt wird und dass zwischen dem RF-Ausgang des Verzerrermischers (VM) und dem Zirkulator ein Isolator eingefügt ist.

9. Schaltungsanordnung nach einem der Ansprüche 4 bis 8, dadurch gekennzeichnet, dass zur Unterdrückung eines RF-Seitenbandes den (Zweiseitenband-) Mischern RF-Kanalfilter nachgeschaltet oder Mischer mit Spiegelunterdrückung verwendet werden.

**Claims**

1. Method of compensating for the nonlinearities of transmission members according to amount and phase in a directional radio transmission system by means of a phase shifter (P), by means of an attenuating member (D), by means of a mixer operating in the linear region (linear mixer LM) and a mixer operating in the distorting region (distorting mixer VM), in which mixers the intermediate frequency (ZF) signal acted on by the wanted signal is translated through the local oscillator (LO) signal into the radio frequency (RF) range, and by means of a summation member (K3), through which both the mixer output signals are combined, wherein the operating point of the distorting mixer (VM) is so set that its output signal (b) apart from the wanted signal component displays substantially only intermodulation products of third order, characterised thereby, that a network is provided, through which the wanted signal component in the output signal (b) of the distorting mixer (VM) is suppressed to a large extent (K1, c), that the network contains an attenuating member (D3) for the setting of the amplitude merely of the remaining intermodulation products of third order, that the network further contains a phase shifter (P) for the setting of the phase position merely of the intermodulation products of third order or merely of the output signal (a) of the linear mixer (LM) and that these signals thus set are combined (d) by the summation member (K3).

2. Method according to claim 1, characterised thereby, that the summation member is a coupler (K3).

3. Method according to claim 1 or 2, characterised thereby, that for the suppression of the wanted signal component, a part of the output signal (a) of the linear mixer (LM) is coupled out (K2) and added in opposite phase to the output signal (b) of the distorting mixer (VM).

4. Circuit arrangement for the performance of the method according to one of the claims 1 to 3, characterised thereby, that the network contains two three-armed couplers (K1, K2), the inputs of which are each connected with a respective mixer output, that the first coupler (K1) connected with the output of the distorting mixer (VM) displays a second input and an output, which input is connected with the first output of the second coupler (K2) and which output is connected through an attenuating member (D3) and through a phase shifter (P) with the first input of a third three-armed coupler (K3), that the second coupler (K2) displays a second output which is connected with the second input of the third coupler (K3), at the output (RFA) of which the predistorted RF-signal (d) can be tapped off.

5. Circuit arrangement according to claim 4, characterised thereby, that a respective attenuating member (D1, D2) is connected in front of or behind each of the ZF-input and the RF-output of the distorting mixer (VM).

6. Circuit arrangement according to claim 4 or 5, characterised thereby, that the second coupler (K2) at its second output and the third coupler (K3) at its second input display a small transmission attenuation (1,5 dB).

7. Circuit arrangement according to claim 4, 5 or 6, characterised thereby, that for the feeding of the LO-signal into the mixers, a further three-armed coupler (K4) is employed, which displays a small transmission attenuation (1,5 dB) at the output connected with the linear mixer and a not so small transmission attenuation (6 dB) at the output connected with the distorting mixer (VM).

8. Circuit arrangement according to one of the claims 4 to 7, characterised thereby, that the first coupler (K1) is replaced by a three-armed circulator and that an isolator is inserted between the circulator and the RF-output of the distorting mixer (VM).

9. Circuit arrangement according to one of the claims 4 to 8, characterised thereby, that for the suppression of an RF-sideband, RF-channel filters are connected behind the (two-sideband) mixers or mixers with image suppression are employed.

**Revendications**

1. Procédé pour la compensation en module et phase des non-linéarités des éléments de transmission d'un faisceau hertzien à l'aide d'un déphaseur (P), d'un atténuateur (D), d'un mélangeur linéaire (LM) et d'un mélangeur-préaccentuateur (VM), dans lesquels le signal à fréquence intermédiaire (ZF) contenant le signal utile est transposé par le signal de l'oscillateur local (LO) dans la gamme de radiofréquence (RF), et à l'aide d'un sommateur (K3) qui réunit les deux signaux de sortie des mélangeurs, le point de fonctionnement du mélangeur-préaccentuateur (VM) étant ajusté de façon que son signal de sortie (b) ne comporte pratiquement en plus de la composante utile que des produits d'intermodulation d'ordre 3, ledit procédé étant caractérisé en ce qu'un réseau est prévu, qui supprime pratiquement (K1, c) la composante utile dans le signal de sortie (b) du mélangeur-préaccentuateur (VM); le réseau comporte un atténuateur (D3) pour réglage de l'amplitude des seuls produits d'intermodulation d'ordre 3 restants; le réseau comporte en outre en déphaseur (P) pour réglage de la phase des seuls produits d'intermodulation d'ordre 3 ou du seul signal de sortie (a) du mélangeur linéaire (LM); et les signaux ainsi réglés sont réunis (d) par le sommateur (K3).

2. Procédé selon revendication 1, caractérisé en ce que le sommateur est un coupleur (K3).

3. Procédé selon une des revendications 1 ou 2, caractérisé en ce que pour la suppression de la composante utile, une partie du signal de sortie (a) du mélangeur linéaire (LM) est découplée (K2), puis additionnée (K1) en opposition de phase avec le signal de sortie (b) du mélangeur-préaccentuateur (VM).

4. Circuit pour la mise en oeuvre du procédé selon une quelconque des revendications 1 à 3, caractérisé en ce que le réseau comprend deux coupleurs à trois branches (K1, K2), dont les entrées sont reliées chacune à une sortie de mélangeur; le premier coupleur (K1) relié à la sortie du mélangeur-préaccentuateur (VM) comporte une seconde entrée, reliée à la première sortie du second coupleur (K2), et une sortie reliée par un atténuateur (D3) et par un déphaseur (P) à la première entrée d'un troisième coupleur à trois branches (K3); et le second coupleur (K2) comporte une seconde sortie, reliée à la seconde entrée du troisième coupleur (K3), sur la sortie duquel (RFA) le signal RF préaccentué (d) peut être prélevé.

5. Circuit selon revendication 4, caractérisé en ce qu'un atténuateur (D1, D2) est branché en amont ou en aval de l'entrée FI et de la sortie RF du mélangeur-préaccentuateur (VM).

6. Circuit selon une des revendications 4 ou 5, caractérisé en ce que la seconde sortie du second coupleur (K2) et la seconde entrée du troisième coupleur (K3) présentent chacune un faible affaiblissement de transmission (1,5 dB).

7. Circuit selon une quelconque des revendications 4 à 6, caractérisé en ce qu'un autre coupleur à trois branches (K4) est utilisé pour l'injection du signal LO dans les mélangeurs et présente un faible affaiblissement de transmission (1,5 dB) sur la sortie reliée au mélangeur linéaire (LM) et un affaiblissement de transmission plus important (6 dB) sur la sortie reliée au mélangeur-préaccentuateur (VM).

8. Circuit selon une quelconque des revendications 4 à 7, caractérisé en ce que le premier coupleur (K1) est remplacé par un circulateur à trois branches; et un isolateur est inséré entre la sortie RF du mélangeur-préaccentuateur (VM) et le circulateur.

9. Circuit selon une quelconque des revendications 4 à 8, caractérisé en ce que pour la suppression d'une bande latérale RF, des filtres de voie RF sont branchés en aval des mélangeurs (à double bande latérale) ou des mélangeurs à suppression de la fréquence image sont utilisés.

FIG.1

FIG.2a

FIG.2b

FIG.2c

FIG.2d